Europäisches Patentamt

European Patent Office

Office européen des brevets

(19)

(11) Numéro de publication: **0 144 264**
**B1**

(12) **FASCICULE DE BREVET EUROPÉEN**

(45) Date de publication du fascicule du brevet:
13.01.88

(51) Int. Cl.⁴: **H 01 L 31/18,** H 01 L 21/265,
H 01 L 29/207

(21) Numéro de dépôt: **84402419.0**

(22) Date de dépôt: **27.11.84**

(54) **Photo-diode à l'antimoniure d'indium, et procédé de fabrication.**

(30) Priorité: **02.12.83 FR 8319317**

(43) Date de publication de la demande:
**12.06.85 Bulletin 85/24**

(45) Mention de la délivrance du brevet:
**13.01.88 Bulletin 88/2**

(84) Etats contractants désignés:
**DE GB NL**

(56) Documents cité:
**FR-A-2 316 727**
**US-A-3 649 369**
**US-A-4 286 277**

(73) Titulaire: **THOMSON- CSF, 173, Boulevard
Haussmann, F-75379 Paris Cédex 08 (FR)**

(72) Inventeur: **Henry, Yves, THOMSON- CSF SCPI 173,
bld Haussmann, F-75379 Paris Cédex 08 (FR)**
Inventeur: **Nicollet, André, THOMSON- CSF SCPI
173, bld Haussmann, F-75379 Paris Cédex 08 (FR)**
Inventeur: **Villard, Michel, THOMSON- CSF SCPI
173, bld Haussmann, F-75379 Paris Cédex 08 (FR)**

(74) Mandataire: **Mayeux, Michèle, THOMSON- CSF
SCPI 19, avenue de Messine, F-75008 Paris (FR)**

## Description

La présente invention concerne les photo-diodes à l'antimoniure d'indium. Elle concerne également divers procédés de fabrication de ces photo-diodes.

La présente invention vise à résoudre le problème suivant:

- d'une part, réalisation de photo-diodes pour l'infra-rouge sur un substrat semi-conducteur en antimoniure d'indium;

- d'autre part, couplage de ces photo-diodes avec un dispositif à transfert de charge réalisant le multiplexage des photo-diodes et la lecture des charges; ce dispositif est réalisé sur un substrat semi- conducteur, généralement en silicium, et présente un canal N. L'utilisation d'un dispositif à canal N, réalisé sur un substrat de type P, permet d'obtenir un très bon rendement d'injection des charges et une forte mobilité des porteurs minoritaires du dispositif qui sont des électrons.

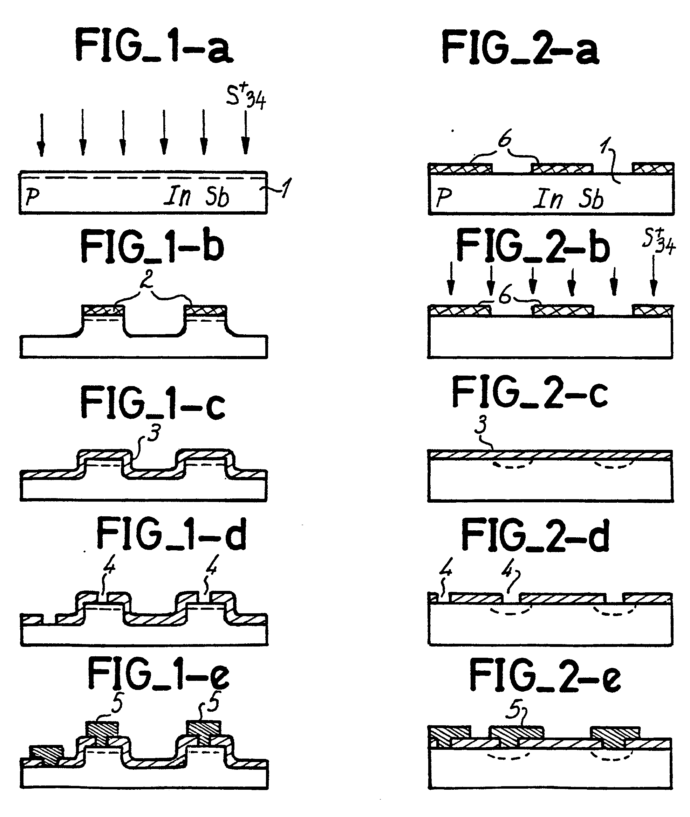

On se reportera par exemple à l'article paru dans la revue I.E.E.E., volume ED 27, n° 1, Janvier 1980, pages 175 à 188, qui est intitulé "CCD Readout of infrared hybrid focal-plane arrays". Cet article montre un dispositif à transfert de charge à canal N couplé à une photo-diode - voir les figures 2 et 5a et leur commentaire.

Dans l'art antérieur, on a réalisé des photo-diodes sur un substrat en antimoniure d'indium de type N. Pour relier ces photo-diodes à un dispositif à transfert de charge à canal N, il faut utiliser une source de courant supplémentaire comme cela est décrit dans la demande de brevet EP-A-0 068 975 au nom de Thomson-CSF. En effet, dans le cas d'un réseau de photo-diodes réalisé sur un substrat de type N, le substrat N est commun à toutes les photo- diodes et seules les régions P des photo-diodes peuvent être reliées au canal N du dispositif à transfert de charge. Comme cela est expliqué dans le brevet cité, on se trouve dans un cas où les charges provenant des photo-diodes sont de signe opposé à celles transférées dans le dispositif à transfert de charge. On est alors conduit à utiliser une source de courant supplémentaire qui injecte dans le dispositif à transfert de charge un courant que l'on peut écrire: a - s, où a est le courant fourni par la source et s le courat provenant d'une photo-diode.

Ces sources de courant supplémentaires sont difficiles à réaliser et compliquent l'ensemble du dispositif.

La présente invention permet de résoudre le problème précédemment énoncé de façon simple et efficace.

La présente invention concerne une photodiode à l'antimoniure d'indium, caractérisée en ce qu'elle comporte sur un substrat en antimoniure d'indium de type P, une implatation ionique de l'isotope $S_{34}^+$ du soufre.

Les photo-diodes selon l'invention peuvent être sans difficultés reliées à un dispositif à transfert de charge à canal N. Ces photo- diodes sont réalisées sur un substrat de type P qui est commun à toutes les photo-diodes et c'est donc leur région N qui est reliée au canal N du dispositif à transfert de charge, sans qu'il y ait besoin de source de courant supplémentaire, puisque les charges provenant des photo-diodes sont de même signe que celles transférées dans le dispositif à transfert de charge.

Il faut noter que les photo-diodes selon l'invention sont de réalisation délicate. En particulier, il n'est pas possible d'obtenir par diffusion des photo-diodes sur un substrat en antimoniure d'indium de type P.

Enfin, il faut noter qu'on a recours pour l'implantation ionique à l'isotope $S_{34}^+$ du soufre. Il s'agit là de l'un des quatre isotopes du soufre parmi lesquels on trouve les isotopes $S_{32}$, $S_{33}$ et $S_{36}$. L'isotope $S_{34}$ ne représente que 4,22 % en poids du soufre. L'utilisation de cet isotope permet d'éviter d'implanter trop d'oxygène en même temps qu'est implanté le soufre. Si l'on utilise l'isotope $S_{32}$, le plus abondant, on implante en même temps que le soufre beaucoup plus d'oxygène. Ceci est dû au fait que 99,76 % de l'oxygène existe sous forme d'isotope $O_{16}$, qui donne pour une molécule d'oxygène de l'oxygène $O_{32}$ susceptible d'être implanté en même temps que le soufre $S_{32}$; alors qu'il n'existe que 0,04 % d'oxygène sous forme de l'isotope $O_{17}$, donnant de l'oxygène $O_{34}$ pour la molécule d'oxygène, et qu'il peut y avoir obtention d'oxygène $O_{34}$ par combinaison d'oxygène $O_{16}$ et d'oxygène $O_{18}$ mais seulement à concurrence de 0,2 % d'oxygène, or c'est cet oxygène $O_{34}$ qui est susceptible d'être implanté en même temps que le soufre $S_{34}$.

D'autres objets, caractéristiques et résultats de l'invention ressortiront de la description suivante, donnée à titre d'exemple non limitatif et illustrée par les figures annexées 1a à e, et 2a à e, qui représente les diverses étapes de procédés de fabrication de photo- diodes selon l'invention.

Sur les différentes figures, les mêmes repères désignent les mêmes éléments, mais, pour des raisons de clarté, les cotes et proportions de divers éléments ne sont pas respectées.

Sur les figures 1a à e, on a représenté les diverses étapes de la fabrication d'une photo-diode selon l'invention.

Sur la figure 1a, on constate que l'on dispose d'un substrat semi-conducteur 1 en antimoniure d'indium 1n Sb de type P. Ce substrat présente un dopage de l'ordre de $10^{15}$ à $10^{16}$ atomes par centimètre cube.

On implante dans ce substrat, ce qui est symbolisé par des flèches verticales sur la figure 1a, des ions de l'isotope $S_{34}^+$ du soufre, avec une énergie de l'ordre de 100 à 200 KeV et à une température de l'ordre de 20 à 150°C. La dose d'implantation est de l'ordre de $5.10^{13}$ à $10^{15}$ atomes par centimètre carré.

Une fois implanté le substrat est recuit à une température comprise entre 350 et 400°c, pendant une durée de l'ordre de 35 à 50 min. Pour éviter la décomposition de l'antimoniure

d'indium, le recuit se fait sous encapsulation, c'est-à-dire que le substrat en antimoniure d'indium est placé entre deux plaques de silicium, bien polies, en contact étroit avec le substrat en antimoniure d'indium.

Le soufre agit comme un donneur d'électrons et provoque la création d'une zone de type N symbolisée par des pointillés sur les figures. On obtient donc une jonction photo-voltaïque. Le recuit réarrange la structure du matériau qui est perturbée sur une épaisseur de 100 à 300 nm (1000 à 3000 Å) environ.

Le recuit place les atomes de soufre dans les lacunes de l'antimoine.

Ensuite - voir figure 1b - on délimite la surface de chaque photodiode par photo-lithogravure. La gravure peut être par exemple chimique, ou électro-chimique, ou ionique.

Sur la figure 1b, on a représenté un dispositif à structure mésa. Les couches 2 en résine photosensible positive ou négative protègent la surface réservée à chaque photodiode.

Ensuite - voir figure 1c - on dépose une couche de diélectrique 3. Le diélectrique peut être déposé par oxydation anodique, par évaporation sous vide, par enduction ou par "sputtering" par exemple. Il peut s'agir d'un diélectrique minéral ou organique. Ainsi on peut déposer par évaporation de l'oxyde de silicium SiO.

Sur la figure 1d, on montre que l'on ouvre des fenêtres 4 permettant d'établir des contacts avec le substrat de type P et avec les implantations de type N.

Sur la figure 1e, on dépose des contacts électriques 5, en métal par exemple, dans les fenêtres 4.

Sur les figures 2a à e, on a représenté les diverses étapes d'un autre procédé de fabrication de photo-diodes selon l'invention.

Sur la figure 2a, on délimite par photogravure l'emplacement des photo-diodes en éliminant une couche de résine photosensible 6 aux endroits réservés aux détecteurs, ainsi on limite l'implantation ionique aux seules zones choisies. On peut utiliser à la place de la résine une couche de matériau diélectrique "dur" qui ne se laisse pas traverser par les ions soufre, c'est le cas de l'oxyde de silicium SiO. On realise donc une structure planar.

Sur la figure 2b, on réalise l'implantation d'ions $S_{34}^+$ dans les mêmes conditions que pour le procédé de la figure 1. Les ions sont reçus sur toute la surface portant les photodiodes.

On assure ensuite le recuit du substrat comme dans le procédé des figures 1a à e.

Sur la figure 2c, on a montré que la résine (ou le matériau diélectrique "dur") était éliminée et que l'on déposait comme sur la figure 1c une couche de diélectrique 3 sur toute la surface.

Sur la figure 2d, on réalise des fenêtres 4 et sur la figure 2e, on place des contacts 5 dans ces fenêtres.

On remarque que sur les figures 2a à e, on a représenté une structure planar.

Dans le cas du procédé des figures 1a à e, au cours de l'étape représentée sur la figure 1a, la totalité du substrat est implantée. Pour réaliser une barrette ou une matrice de photo-diodes, il faut utiliser une structure mésa pour délimiter les photo-diodes. Par contre si l'on ne désire réaliser qu'une seule photo-diode, on peut utiliser une structure planar, dans le cadre du procédé des figures 1a à e qui commence par l'implantation.

Dans le cas du procédé des figures 2a à e, on peut utiliser une structure mésa. Après l'implantation et le recuit de la figure 2b, il faut réaliser les mésas autour des zones implantées.

**Revendications**

1. Photo-diode à l'antimoniure d'indium, caractérisée en ce qu'elle comporte sur un substrat en antimoniure d'indium (1) de type P, une implatation ionique de l'isotope $S_{34}^+$ du soufre.

2. Procédé de fabrication d'une photo-diode selon la revendication 1, caractérisé en ce qu'il consiste à réaliser une implantation ionique de l'isotope $S_{34}^+$ du soufre dans un substrat (1) en antimoniure d'indium de type P, puis à recuire le substrat implanté.

3. Procédé selon la revendication 2, caractérisé en ce que:
- le dopage du substrat (1) en antimoniure d'indium de type P est de l'ordre de $10^{15}$ à $10^{16}$ atomes par centimètre cube;
- l'implantation d'ions $S_{34}^+$ a lieu avec une énergie de l'ordre de 100 à 200 KeV, à une température de l'ordre de 20 à 150°C, et la dose d'implantation est de l'ordre de $5.10^{13}$ à $10^{15}$ atomes par centimètre carré;
- le recuit s'effectue sous encapsulation à une température comprise entre 350 et 400°C, et pendant une durée de l'ordre de 35 à 50 min.

4. Procédé selon l'une des revendications 2 ou 3, caractérisé en ce que:
- on realise l'implantation et le recuit du substrat (figure 1a);
- on délimite par photogravure la surface réservée à chaque photo-diode en formant une structure mésa (figure 1b);
- on dépose une couche de diélectrique (3) sur toute la surface (figure 1c);
- on ouvre des fenêtres (4) dégageant le substrat de type P et les implantations et on dépose des contacts électriques (5) (figures 1d et e).

5. Procédé selon l'une des revendications 2 ou 3, caractérisé en ce que:
- on délimite par photogravure la surface réservée à chaque photo-diode en ouvrant des fenêtres dans un résine photosensible ou un matériau diélectrique (6) déposé à la surface du substrat (figure 2a);
- on réalise l'implantation et le recuit du substrat, les zones à implanter étant délimitées par les fenêtres de la résine photosensible ou du mmatériau diélectrique (6) (figure 2b);

- on dépose une couche de diélectrique (3) sur toute la surface (figure 2c);
- on ouvre des fenêtres (4) dégageant le substrat de type P et les implantations et on dépose des contacts électriques (5) (figures 2d et c).

**Patentansprüche**

1. Indiumantimonid-Fotodiode, dadurch gekennzeichnet, daß sie auf einem Substrat aus Indiumantimonid (1) vom P-Typ eine Ionenimplantation des Schwefelisotops $S_{34}^+$ aufweist.

2. Verfahren zur Herstellung einer Fotodiode nach Anspruch 1, dadurch gekennzeichnet, daß es darin besteht, eine Ionenimplantation des Schwefelisotops $S_{34}^+$ in einem Substrat (1) aus Indiumantimonid vom P-Typ herbeizuführen und dann das dotierte Substrat mit Wärme zu behandeln.

3. Verfahren nach Anspruch 2, dadurch gekennzeichnet:
- daß die Dotierung des Substrats (1) aus Indiumantimonid vom P-Typ zwischen $10^{15}$ und $10^{16}$ Atomen pro $cm^3$ liegt;
- daß die Implantierung der $S_{34}^+$ Ionen mit einer Energie in der Größenordnung von 100 bis 200 keV und bei einer Temperatur zwischen 20 und 150°C erfolgt, wobei die Implantationsdosis zwischen $5 \cdot 10^{13}$ und $10^{15}$ Atomen pro $cm^2$ liegt;
- daß die Wärmebehandlung in einem geschlossenen Behälter bei einer Temperatur zwischen 350 und 400°C und während einer Dauer von 35 bis 50 Minuten erfolgt.

4. Verfahren nach einem der Ansprüche 2 oder 3, dadurch gekennzeichnet:
- daß die Implantierung und die Wärmebehandlung des Substrats durchgeführt wird (Fig. 1a);
- daß durch Fotogravur die für jede Fotodiode reservierte Oberfläche begrenzt wird, indem eine Plateau-Struktur gebildet wird (Fig. 1b);
- daß eine Schicht (3) aus einem Dielektrikum auf die ganze Oberfläche aufgebracht wird (Fig. 1c);
- daß Fenster (4) geöffnet werden, die das Substrat vom P-Typ und die Implantierungen freilegen und daß elektrische Kontakte (5) aufgebracht werden (Fig. 1d und 1e).

5. Verfahren nach einem der Ansprüche 2 oder 3, dadurch gekennzeichnet:
- daß die für jede Fotodiode reservierte Oberfläche durch Fotogravur begrenzt wird, indem Fenster in einem lichtempfindlichen Harz oder einem auf die Oberfläche des Substrats aufgebrachten dielektrischen Material geöffnet werden (Fig. 2a);
- daß die Implantierung und Wärmebehandlung des Substrats erfolgt, wobei die zu dotierenden Zonen durch die Fenster des lichtempfindlichen Harzes oder des dielektrischen Materials (6) begrenzt werden (Fig. 2b);
- daß eine Schicht eines Dielektrikums (3) auf die ganze Oberfläche aufgebracht wird (Fig. 2c);
- daß Fenster (4) geöffnet werden, die das Substrat vom P-Typ und die Implantierungen freilegen, und daß elektrische Kontakte (5) aufgebracht werden (Fig. 2d und c).

**Claims**

1. An indium antimonide photodiode, characterized in that it comprises on a substrate made of indium antimonide (1) of the P type a ionic implantation of the sulfur isotope $S_{34}^+$.

2. A method for manufacturing a photodiode according to claim 1, characterized in that it consists in realizing a ionic implantation of the sulfur isotope $S_{34}^+$ in a substrate (1) made of indium antimonide of the P type, followed by a thermal treatment of the doped substrate.

3. A method according to claim 2, characterized in that
- the doping of the substrate (1) of indium antimonide of the P type is rated between $10^{15}$ and $10^{16}$ atoms per $cm^3$;
- the implantation of ions $S_{34}^+$ takes place with an energy of between 100 and 200 keV, at a temperature between 20 and 150°C and at an implantation rate of between $5 \cdot 10^{13}$ und $10^{15}$ atoms per $cm^2$;
- the thermal treatment takes place in a tight chamber at a temperature between 350 and 400°C and for a duration of between 35 and 50 minutes.

4. A method according to one of claims 2 or 3, characterized in that
- the implantation and thermal treatment of the substrate takes place (fig. 1a);
- the surface attributed to each photodiode is delimited by the constitution of a mesa structure (fig. 1b);
- a layer of dielectricum (3) is deposited on the entire surface (fig. 1c);
- windows (4) are opened which render apparent the substrate of the P type and the implantations, and electrical contacts (5) are deposited (fig. 1d and e).

5. A method according to one of claims 2 or 3, characterized in that
- the surface attributed to each photodiode is delimited by photo-engraving, by opening windows in a photosensitive resin or a dielectric material (6) deposited on the surface of the substrate (fig. 2a);
- the implantation and the thermal treatment of the substrate takes place, the zones to be doped being delimited by the windows of the photosensitive resin or of the dielectric material (6) (fig. 2b);
- a layer of dielectric material (3) is deposited on the entire surface (fig. 2c);
- windows (4) are opened which render apparent the substrate of the P type and the implantations, and electrical contacts (5) are deposited (fig. 2d and 2c).

# FIG_1-a

$S^+_{34}$

| P | In Sb | 1 |

# FIG_2-a

6    1

| P | In Sb |

# FIG_1-b

2

# FIG_2-b

$S^+_{34}$

6

# FIG_1-c

3

# FIG_2-c

3

# FIG_1-d

4    4

# FIG_2-d

4    4

# FIG_1-e

5    5

# FIG_2-e

5